Europäisches Patentamt

European Patent Office

Office européen des brevets

(19)

(11) Veröffentlichungsnummer: **0 145 648**
**B1**

(12) # EUROPÄISCHE PATENTSCHRIFT

(45) Veröffentlichungstag der Patentschrift:
14.10.87

(21) Anmeldenummer: 84810440.2

(22) Anmeldetag: 10.09.84

(51) Int. Cl.⁴: **B 05 C 5/00,** H 05 K 3/34,
G 03 F 7/16

(54) **Beschichtungsvorrichtung.**

(30) Priorität: 15.09.83 CH 5031/83

(43) Veröffentlichungstag der Anmeldung:
19.06.85 Patentblatt 85/25

(45) Bekanntmachung des Hinweises auf die Patenterteilung:
14.10.87 Patentblatt 87/42

(84) Benannte Vertragsstaaten:
AT BE CH DE FR GB IT LI NL SE

(56) Entgegenhaltungen:
EP-A-0 002 040
DE-A-2 014 822
DE-A-2 542 819
GB-A-2 021 001
US-A-4 060 649

(73) Patentinhaber: CIBA- GEIGY AG, Klybeckstrasse
141, CH- 4002 Basel (CH)

(72) Erfinder: Bossard, Alfred Ernst, Junkholzstrasse 3,
CH- 8968 Mustschellen (CH)
Erfinder: Kuster, Kaspar, Baselmattweg 203, Ch-
4123 Allschwil (CH)

## Beschreibung

Die Erfindung betrifft eine Beschichtungsvorrichtung gemäss dem Oberbegriff des Patentanspruchs 1.

Eine derartige Beschichtungsvorrichtung (Giessmaschine) ist z. B. in US-A-4 060 649 beschrieben. Im Zusammenhang mit der Erzeugung von Lötstoppmasken auf Leiterplatten ist ferner eine weitere Vorrichtung dieser Art in EP-A-2040 dargestellt und erläutert.

Bei diesen bekannten Beschichtungsvorrichtungen wird der von einem Giesskopf erzeugte und auf das zu beschichtende Objekt niedersinkende Giessvorhang zwischen zwei seitlichen Kantenführungen geleitet und dadurch stabilisiert. Erfahrungsgemäss ist dabei die Dicke des Giessvorhangs in unmittelbarer Nähe der Kantenführungen erheblich grösser als im zentralen Bereich des Vorhangs. Bei der Randlos-Beschichtung, wenn also die gesamte Oberfläche des Objekts beschichtet wird, spielt dieser Effekt keine Rolle, da dann die Vorhangbreite ohne weiteres so gross gewählt werden kann, dass die dickeren Randpartien des Giessvorgangs zu beiden Seiten des Objekts vorbeifliessen und somit gar nicht erst auf das Objekt gelangen (US-A-4 060 649). Anders ist dies jedoch in Fällen, in denen aus irgendwelchen Gründen Randzonen des Objekts nicht beschichtet werden sollen, die Breite des Vorhangs also geringer als die des zu beschichtenden Objekts sein muss. In diesen Fällen entstehen dann aufgrund der verdickten Randwülste im Giessvorhang entsprechend verdickte Beschichtungsränder, welche oftmals nicht toleriert werden können.

Durch die vorliegende Erfindung soll nun eine Beschichtungsvorrichtung der zur Rede stehenden Art dahingehend verbessert werden, dass unerwüscht dicke Beschichtungsränder weitestgehend vermieden werden.

Die erfindungsgemässe Beschichtungsvorrichtung, die dieser Aufgabe gerecht wird, ist im Patentanspruch 1 beschrieben. Bevorzugte und besonders zweckmässige Weiterbildungen und Ausgestaltungen sind in den abhängigen Ansprüchen beschrieben.

Im folgenden wird eine erfindungsgemässe Beschichtungsvorrichtung anhand von in der Zeichnung dargestellten Ausführungsbeispielen näher erläutert. Es zeigen:.

Fig. 1: eine perspektivische Skizze der wichtigsten Elemente der Beschichtungsvorrichtung und

Fig. 2-4: stark schematisierte Skizzen diverser Detailvarianten.

Die dargestellte Beschichtungsvorrichtung umfasst eine Transportbahn T für zu beschichtende Objekte O, hier z. B. Leiterplatten, und einen langgestreckten, quer zur Bewegungsrichtung (Pfeil P) der Transportbahn T verlaufenden Giesskopf H sowie diverse aus Gründen der Übersichtlichkeit nicht dargestellte Leitungen und Antriebe. Sämtliche Teile sind natürlich in einem ebenfalls nicht gezeigten Maschinengestell angeordnet bzw. befestigt.

Im Betrieb erzeugt der Giesskopf H einen durch zwei seitliche Führungen P begrenzten und stabilisierten Giessvorhang C, der frei fallend auf das auf der Transportbahn T unter dem Giesskopf H durchgeführte zu beschichtende Objekt O niedersinkt und dort eine Beschichtung B erzeugt.

Soweit entspricht die Beschichtungsvorrichtung dem Stand der Technik, sodass sich eine detailliertere Beschreibung erübrigt.

Erfahrungsgemäss ist die Dicke des Giessvorhangs C nicht über die gesamte Breite konstant, sondern es bildet sich an den - unumgänglichen - seitlichen Führungen F unvermeidlicherweise ein ausgeprägter Randwulst aus, der je nach rheologischen Eigenschaften des Beschichtungsmaterials mehr oder weniger weit in den mittleren Vorhangbereich hineinreicht. Die Breiten dieser verdickten Randbereiche betragen in der Regel etwa 5-15 mm.

Wenn das Objekt O vollständig beschichtet werden soll, spielt dieser Effekt keine wesentliche Rolle, da dann einfach die Vorhangbreite entsprechend grösser gewählt werden kann, sodass die verdickten Randbereiche seitlich am Objekt vorbeifallen und somit erst gar nicht auf das Objekt gelangen und dort die Gleichmässigkeit der Beschichtung beeinträchtigen können. Wenn jedoch die Breite der Beschichtung geringer sein soll als die Objektbreite, also auf diesem ein- oder beidseits ein Randstreifen unbeschichtet bleiben soll, kommt der genannte Effekt voll zur Auswirkung und erzeugt an den seitlichen Rändern der Beschichtung eine erhebliche Verdickung, die in vielen Fällen untragbar oder zumindest unerwünscht ist und bei der weiteren Ver- oder Bearbeitung des beschichteten Objekts zu Schwierigkeiten führen kann.

Um nun diesen Mangel der bekannten Giessvorrichtungen abzuhelfen, sind gemäss der Erfindung zu beiden Seiten des Giessvorhangs C übereinander zwei Trennorgane 10 und 20 sowie zwei an diese anschliessende Kantenführungen 30 und 40 vorgesehen. Jedes Trennorgan besteht aus einem zur Vorhangebene im wesentlichen senkrecht angeordneten und zur Vertikalen V in einem spitzen Winkel angestellten Messer 11 bzw. 21, welches in eine geneigte Ableitrinne 12 bzw. 22 übergeht. Die beiden Kantenführungen 30 und 40 schliessen sich unmittelbar an die Schneiden der Messer 11 und 21 an und reichen bis zum Messer 21 des unteren Trennorgans 20 bzw. bis knapp an die Oberfläche des zu beschichtenden Objekts O.

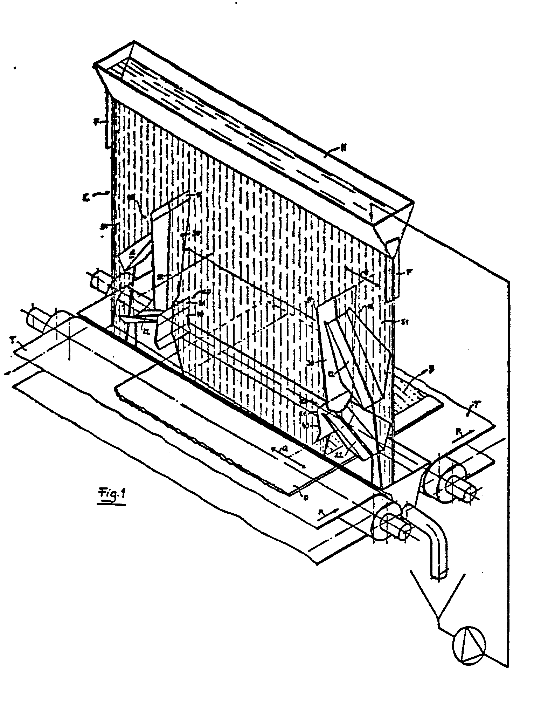

Die beiden Trennorgane 10 und 20 in Verbindung mit den beiden Kantenführungen 30 und 40 dienen zur seitlichen Begrenzung des Giessvorhangs C und zur Beseitigung bzw. weitestgehenden Unterdrückung von Randwülsten im Vorhang und in der Beschichtung auf dem Objekt. Wie aus Fig. 1 ohne weiteres erhellt, schneiden die beiden - bezogen auf die Fallrichtung des Vorhangs C - hintereinander angeordneten Trennorgane 10 und 20 in zwei Stufen zwei Randstreifen 51 und 52 des Giessvorhangs C ab und leiten das überschüssige Beschichtungsmaterial aus den abgeschnittenen Randstreifen seitlich weg. Die obere Kantenführung 30 leitet den erstmals verschmälerten Vorhang zum Messer 21 des unteren Trennorgans 20 und die untere Kantenführung 40 führt den zum zweiten Mal verschmälerten Vorhang dann bis unmittelbar an das Objekt O.

Der überwiegende Randbereich 51 des Giessvorhangs C wird vom oberen Trennorgan 10 abgeschnitten. Auf dem Weg vom Messer 11 entlang der Kantenführung 30 bildet sich am verschmälerten Giessvorhang ein neuer Randwulst aus. Dieser wird nun vom unteren Trennorgan 20 abgeschnitten. Da sich dieses Trennorgan 20 gemäss einem Hauptgedanken der Erfindung nur wenig oberhalb der Transportbahn befindet und die Kantenführung 40 dementsprechen kurz ist, kann sich entlang dieser kein nennenswerter neuer Randwulst mehr ausbilden, welcher zu einer untolerierbaren Verdickung der Beschichtungsränder führen könnte.

Die wesentliche Bedeutung kommt also dem unteren Trennorgan 20, seiner tiefen Anordnung und der kurzen Ausbildung seiner Kantenführung 40 zu. Bei fester Breite der zu erzeugenden Beschichtung können das obere Trennorgan 10 und die Kantenführung 30 entfallen, wobei dann die seitliche Führung F die Rolle der letzteren übernimmt. Die weiter unten stehenden Ausführungen bezüglich der Formgebung der oberen Kantenführung 30 gelten daher sinngemäss auch für die seitlichen Führungen.

Zur Erzeugung verschieden breiter Beschichtungen ist das untere Trennorgan 20 zusammen mit seiner Kantenführung 40 parallel zur Längserstreckung des Giesskopfs verstellbar angeordnet, was durch den Doppelpfeil Q symbolisiert ist. Unter anderem auch aus Gründen der problemlosen Ableitbarkeit des überschüssigen Beschichtungsmaterials ist es von Wichtigkeit, dass der vom unteren Trennorgan 20 abgeschnittene Randbereich 52 des Giessvorhangs C relativ schmal - beispielsweise etwa 8 bis 20 mm ist. Um diese Bedingung in jeder Position des unteren Trennorgans 20 einzuhalten, ist das obere Trennorgan 10 mit seiner Kantenführung 30 vorgesehen und dieses Trennorgan in fixer Zuordnung zum unteren Trennorgan 20 gemeinsam mit diesem verstellbar angeordnet (Pfeil Q). Selbstverständlich könnte an Stelle des oberen Trennorgans 10 natürlich auch die seitliche Führung F entsprechend beweglich angeordnet sein. Die gegenseitige Lage der beiden Trennorgane 10 und 20 ist bei Bedarf justierbar.

Die Ausbildung bzw. Formgebung der Kantenführungen 30 und 40 bzw. bei fehlendem oberen Trennorgan 10 der seitlichen Führung F hängt in gewissem Masse von den rheologischen Eigenschaften des Beschichtungsmaterials ab. Generell ist es vorteilhaft, wenn der unterste Abschnitt 31 der ansonsten im wesentlichen vertikalen Kantenführung 30 (bzw. sinngemäss der seitlichen Führung F) im Sinne einer Vorhangverbreiterung auswärts geneigt ist. Der Neigungswinkel $\gamma$ (Fig. 2) beträgt dabei etwa 1 bis 5 Grad. Die Länge 1 des geneigten Abschnitts 31 beträgt etwa 60 bis 80 mm (bezogen auf die üblichen Gesamtvorhanghöhen von etwa 100 bis 120 mm). Durch diesen auswärts geneigten Abschnitt 31 wird der Randbereich 52 des Vorhangs C kurz vor dem Abtrennen gespreizt, wodurch der Randwulst und der genannte Randbereich 52 verdünnt und so der Entstehung eines neuen Randwulsts entlang der unteren Kantenführung 40 entgegengewirkt wird.

Zur Erzielung von definierten Strömungsverhältnissen ist es von Bedeutung, dass die Kantenführung 30 bis zum unteren Trennorgan 20 hinunterreicht, d.h., die Unterkante 32 der Kantenführung 30 (oder der seitlichen Führung F) muss im wesentlichen auf oder unter dem Niveau der Schneide 23 (des Eingriffspunkts des Messers 21 in den Vorhang C) liegen (Fig. 2).

Die untere Kantenführung 40 kann je nach den rheologischen Eigenschaften des Beschichtungsmaterials verschieden ausgebildet sein. Der Abstand h der Schneide 23 des Trennmessers 21 von der Oberfläche des zu beschichtenden Objekts O ist möglichst gering und beträgt mit Vorzug etwa 30 bis 40 mm. Die Unterkante 43 der Kantenführung 40 reicht möglichst nahe an das Objekt O heran, ist jedoch weit genug entfernt, um auch bei den beim Transport zu erwartenden vertikalen Bewegungen des Objekts eine direkte Berührung zu vermeiden. Praktische Werte für die Distanz d betragen 3 bis 5 mm.

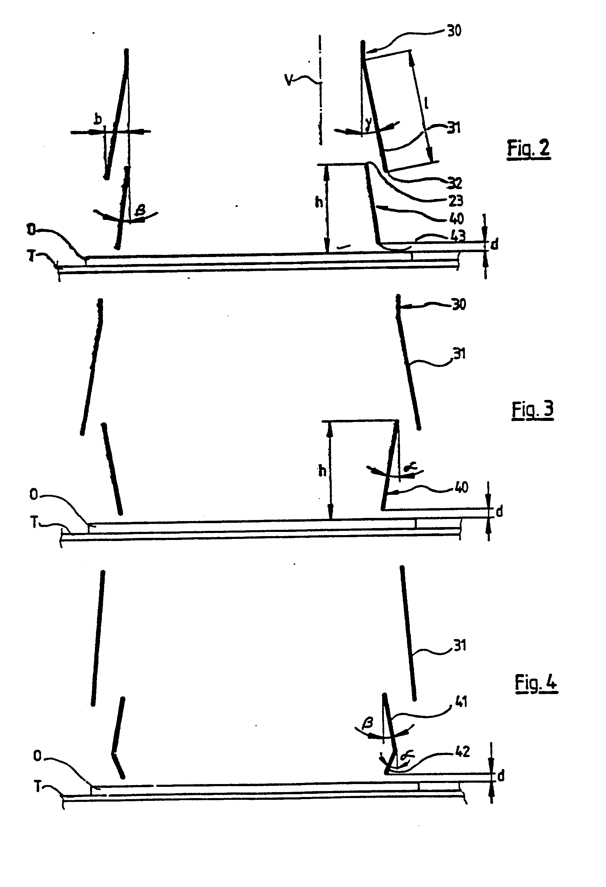

Die Kantenführung 40 kann um einen Winkel $\alpha$ von 0 bis 5 Grad einwärts (Fig. 3) oder um einen Winkel $\beta$ von 0 bis 5 Grad auswärts (Fig. 2) geneigt sein. Für die in der eingangs erwähnten EP-A-2040 angeführten Beschichtungsmassen ist es von besonderem Vorteil, wenn die Kantenführung 40 aus zwei Abschnitten 41 und 42 besteht, von denen der obere auswärts und der untere einwärts geneigt ist (Fig. 4). Mit dieser Konfiguration lassen sich besonders stabile Strömungsverhältnisse und ensprechend qualitativ befriedigende Beschichtungen erzielen.

Die Breite b des vom unteren Trennorgan 20 abgeschnittenen Randbereichs 52 des Vorhangs C beträgt etwa 8 bis 50 mm.

## Patentansprüche

1. Beschichtungsvorrichtung mit einer Transportbahn für ein zu beschichtendes Objekt und einem sich oberhalb der Transportbahn quer zu dieser erstreckenden Giesskopf zur Erzeugung eines frei fallenden Giessvorhangs, mit seitlichen Führungen für den Vorhang, mit einem zur seitlichen Begrenzung des Giessvorhangs (C) an wenigstens einer seiner Kanten in den Giessvorhang seitlich hineinragenden, die Vorhangbreite beschneidenden und das aus dem abgeschnittenen Randstreifen (52) des Vorhangs stammende Beschichtungsmaterial seitlich wegführenden Trennorgan (20) sowie mit einer Kantenführung (40) für den verschmälerten Giessvorhang, dadurch gekennzeichnet, dass das Trennorgan (20) im Bereich von etwa 30-40 mm oberhalb der Auftreffstelle des Giessvorhangs in diesen eingreift und dass die Kantenführung (40) vom Eingriffspunkt (23) des Trennorgans (20) bis etwa 3-5 mm oberhalb der Auftreffstelle des Giessvorhangs auf dem zu beschichtenden Objekt (O) reicht.

2. Vorrichtung nach Anspruch 1, dadurch gekennzeichnet, dass das Trennorgan (20) im wesentlichen nur etwa den gegenüber dem Mittenbereich verdickten Randbereich (52) des Giessvorhangs (C) abschneidet.

3. Vorrichtung nach Anspruch 2, dadurch gekennzeichnet, dass der abgeschnittene Randbereich (52) etwa 6-12 mm, vorzugsweise 8-10 mm breit ist.

4. Vorrichtung nach einem der Ansprüche 1-3, dadurch gekennzeichnet, dass die seitliche Führung (30; F) des Giessvorhangs unmittelbar oberhalb des Trennorgans (20) einen auswärts geneigten Abschnitt (31) aufweist, der eine Verbreiterung des Vorhangs vor dem Kontakt mit dem Trennorgan (20) bewirkt.

5. Vorrichtung nach Anspruch 4, dadurch gekennzeichnet, dass die seitliche Führung (30; F) des Giessvorhangs bis wenigstens auf das Niveau des Eingriffspunkts (23) des Trennorgans (20) herabreicht.

6. Vorrichtung nach einem der Ansprüche 1-5, dadurch gekennzeichnet, dass die Kantenführung (40) einen nach unten einwärts geneigten, eine leichte Breitenverringerung des Giessvorhangs bewirkenden Abschnitt (42) aufweist.

7. Vorrichtung nach einem der Ansprüche 1-5, dadurch gekennzeichnet, dass die Kantenführung (40) einen nach unten auswärts geneigten, eine leichte Verbreiterung des Giessvorhangs bewirkenden Abschnitt (41) aufweist.

8. Vorrichtung nach Anspruch 6 und 7, dadurch gekennzeichnet, dass die Kantenführung (40) in ihrem oberen Teil (41) leicht auswärts und in ihrem unteren Teil (42) leicht einwärts geneigt ist.

9. Vorrichtung nach Anspruch 6, dadurch gekennzeichnet, dass der Neigungswinkel ($\alpha$) des einwärts geneigten Abschnitts (42) der Kantenführung gegenüber der Vertikalen etwa 1 bis 8 Grad beträgt.

10. Vorrichtung nach Anspruch 7, dadurch gekennzeichnet, dass der Neigungswinkel ($\beta$) des auswärts geneigten Abschnitts (41) der Kantenführung (40) gegenüber der Vertikalen etwa 1 bis 8 Grad beträgt.

11. Vorrichtung nach Anspruch 4, dadurch gekennzeichnet, dass der Neigungswinkel ($\gamma$) des auswärts geneigten Abschnitts (31) der seitlichen Führung (30; F) etwa 0 bis 5 Grad beträgt.

12. Vorrichtung nach einem der Ansprüche 1-11, dadurch gekennzeichnet, dass das Trennorgan (20) eine geneigte Rinne (22) zum Ableiten des abgeschnittenen Beschichtungsmaterials aufweist.

13. Vorrichtung nach einem der Ansprüche 1-12, dadurch gekennzeichnet, dass oberhalb des genannten Trennorgans (20) ein zweites Trennorgan (10) sowie daran anschliessend eine zweite Kantenführung (30) vorgesehen sind, welche einen ersten Randbereich (51) des Giessvorhangs abschneiden und wegleiten und den so verschmälerten Giessvorhang an das erstgenannte Trennorgan (20) heranführen, welches dann einen zweiten Randbereich (52) abschneidet.

14. Vorrichtung nach Anspruch 13, dadurch gekennzeichnet, dass die zweite Kantenführung (30) wie die seitliche Führung (F) gemäss einem der Ansprüche 4, 5 und 11 ausgebildet ist.

15. Vorrichtung nach Anspruch 13 oder 14, dadurch gekennzeichnet, dass die beiden Trennorgane (10, 20) zusammen mit ihren Kantenführungen (30, 40) zur Einstellung der Giessvorhangbreite gemeinsam parallel zum Giesskopf (H) verstellbar sind.

## Claims

1. Coating apparatus comprising a conveyer belt for an object to be coated and a pouring head extending above the conveyer belt transversely thereto, for producing a freefalling poured curtain, lateral guiding means for the curtain, a severing tool (20) laterally projecting for the lateral limitation of the poured curtain (C), into the poured curtain at least at one of its edges, trimming the width of the curtain and laterally removing the coating material derived from the cut-off marginal strip (52) of the curtain as well as an edge-guiding means (40) for the narrowed-down poured curtain, characterized in that the severing tool (20) intrudes into the poured curtain in a region of about 30 to 40 mm above the place of impingement of the same and that the edge-guiding means (40) extends from the point of intrusion (23) of the severing tool (20) to about 3 to 5 mm above the place of impingement of the poured curtain onto the object (O) to be coated.

2. Apparatus according to Claim 1, characterized in that the severing tool (20) essentially cuts off only approximately the marginal region (52) of the poured curtain (10), thickened relative to its central region.

3. Apparatus according to Claim 2, characterized in that the cut-off marginal region (52) is about 6 to 12 mm, preferably 8 to 10 mm, wide.

4. Apparatus according to one of Claims 1 to 3, characterized in that the lateral guiding means (30; F) of the poured curtain is provided immediately above the servering tool (20) with an outwardly inclined section (31) which effects a broadening of the curtain prior to its contact with the servering tool (20).

5. Apparatus according to Claim 4, characterized in that the lateral guiding means (30; F) of the poured curtain extends downwardly at least to the level of the point of intrusion (23) of the severing tool (20).

6. Apparatus according to one of Claims 1 to 5, characterized in that the edge-guiding means (40) has an inwardly inclined section (42) effecting a slight reduction of the width of the poured curtain.

7. Apparatus according to one of Claims 1 to 5, characterized in that the edge-guiding means (40) have an outwardly inclined section (41) effecting a slight widening of the poured curtain.

8. Apparatus according to Claims 6 and 7, characterized in that the edge-guiding means (40) is slightly outwardly inclined in its upper section (41) and slightly inwardly in its lower section (42).

9. Apparatus according to Claim 6, characterized in that the angle of inclination (α) of the inwardly inclined section (42) of the edge-guiding means relative to the perpendicular amounts to about 1 to 8 degrees.

10. Apparatus according to Claim 7, characterized in that the angle of inclination (β) of the outwardly inclined section (41) of the edge-guiding means (40) relative to the perpendicular amounts to about 1 to 8 degrees.

11. Apparatus according to Claim 4, characterized in that the angle of inclination (γ) of the outwardly inclined section (31) of the lateral guiding means (30; F) amounts to about 0 to 5 degrees.

12. Apparatus according to one of Claims 1 to 11, characterized in that the severing tool (20) has an inclined chute (22) for leading away the cut-off coating material.

13. Apparatus according to one of Claims 1 to 12, characterized in that above the said severing tool (20) there are provided a second severing tool (10) as well as, adjacent thereto a second edge-guiding means (30) which cuts off and leads away a first marginal region (51) of the poured curtain and leads the thus narrowed poured curtain to the first named severing tool (20) which then cuts off the second marginal region (52).

14. Apparatus according to Claim 13, characterized in that the second edge-guiding means (30) is designed like the lateral guiding means (F) in accordance with one of Claims 4, 5 and 11.

15. Apparatus according to Claim 13 or 14, characterized in that the two severing tools (10, 20) together with their edge-guiding means (30, 40) are adjustable together parallel with the pouring head (H) for adjusting the width of the poured curtain.

**Revendications**

1. Dispositif d'enduction comprenant une bande transporteuse pour un objet à recouvrir d'une couche mince, une tête de coulée s'étendant au-dessus de la bande transporteuse transversalement à celle-ci pour la production d'un rideau liquide tombant librement, des guidages latéraux guidant le rideau, un organe de séparation (20) faisant saillie latéralement dans le rideau liquide (C) pour le limiter sur les côtés sur au moins une de ses arêtes, coupant la largeur du rideau liquide et écartant latéralement le matériau d'enduction provenant de la bande marginale (52) découpée du rideau, ainsi qu'un guidage (40) pour le rideau liquide rétréci, caractérisé par le fait que l'organe de séparation (20) s'engage dans le rideau liquide dans une zone située à environ 30-40 mm au-dessus du point d'impact du rideau liquide sur l'objet à enduire (0) et que le guidage (40) s'étend depuis le point d'engagement (23) de l'organe de séparation (20) jusqu'à environ 3-5 mm au-dessus du point d'impact du rideau liquide sur l'objet à enduire (O).

2. Dispositif selon la revendication 1, caractérisé par le fait que l'organe de séparation (20) ne découpe pour l'essentiel à peu près que la zone marginale (52) du rideau liquide (C) qui est légèrement épaissie par rapport à la zone médiane.

3. Dispositif selon la revendication 2, caractérisé par le fait que la zone marginale découpée (52) a une largeur d'environ 6-12 mm, de préférence de 8-10 mm.

4. Dispositif selon l'une des revendications 1-3, caractérisé par le fait que le guidage latéral (30; F) du rideau liquide immédiatement au-dessus de l'organe de séparation (20) présente une section (31) inclinée vers l'extérieur qui provoque un élargissement du rideau avant le contact avec l'organe de séparation (20).

5. Dispositif selon la revendication 4, caractérisé par le fait que le guidage latéral (30; F) du rideau liquide descend au moins jusqu'au niveau du point d'engagement (23) de l'organe de séparation (20).

6. Dispositif selon l'une des revendications 1-5, caractérisé par le fait que le guidage (40) comporte une section (42) qui, inclinée en descendant vers l'intérieur, provoque un léger rétrécissement du rideau liquide.

7. Dispositif selon l'une des revendications 1-5, caractérisé par le fait que le guidage (40) comporte une section (41) qui, inclinée en descendant vers l'extérieur, provoque un léger élargissement du rideau liquide.

8. Dispositif selon les revendications 6 et 7, caractérisé par le fait que le guidage (40) est légèrement incliné vers l'extérieur dans sa partie supérieure (41) et légèrement incliné vers l'intérieur dans sa partie inférieure (42).

9. Dispositif selon la revendication 6, caractérisé par le fait que l'angle d'inclinaison α de la section (42), inclinée vers l'intérieur, du guidage, est d'environ 1 à 8° par rapport à la verticale.

10. Dispositif selon la revendication 7, caractérisé par le fait que l'angle d'inclinaison β de la section (41), inclinée vers l'extérieur, du guidage (40), est d'environ 1 à 8° par rapport à la verticale.

11. Dispositif selon la revendication 4, caractérisé par le fait que l'angle d'inclinaison γ de la section (31), inclinée vers l'extérieur, du guidage latéral (30; F) est d'environ 0 à 5°.

12. Dispositif selon l'une des revendications 1-11, caractérisé par le fait que l'organe de séparation (20) comporte une goulotte inclinée (22) pour dériver le matériau d'enduction découpé.

13. Dispositif selon l'une des revendications 1-12, caractérisé par le fait qu'au-dessus de l'organe de séparation cité (20), il est prévu un second organe de séparation (10) ainsi qu'un second guidage (30) s'y raccordant, lesquels découpent et écartent une première zone marginale (51) du rideau liquide et font passer le rideau liquide ainsi rétréci devant l'organe de séparation (20) cité en premier qui découpe alors une seconde zone marginale (52).

14. Disoositif selon la revendication 13, caractérisé par le fait que le second guidage (30) de même que le guidage latéral (F) sont réalisés conformément à l'une des revendications 4, 5 et 11.

15. Dispositif selon la revendication 13 ou 14, caractérisé par le fait que les deux organes de séparation (10, 20) avec leurs guidages (30, 40) peuvent être déplacés en commun parallèlement à la tête de coulée (H) pour regler la largeur du rideau liquide.

Fig.1

_Fig. 2_

_Fig. 3_

_Fig. 4_